# EUROPEAN PATENT SPECIFICATION

(11) **EP 3 522 693 B1**
(45) Date of publication and mention of the grant of the patent: **13.12.2023**
(21) Application number: 16917703.7
(22) Date of filing: 29.09.2016
(51) Int. Cl.: H05K 13/04, H05K 13/08

(54) **COMPONENT MOUNTING APPARATUS**
KOMPONENTENMONTAGEVORRICHTUNG
APPAREIL DE MONTAGE DE COMPOSANT

(43) Date of publication of application: 07.08.2019
(73) Proprietor: Fuji Corporation, Chiryu-shi, Aichi 472-8686 (JP)
(72) Inventor: NARITA, Junichi, Chiryu, Aichi, (JP)
(74) Representative: Grünecker Patent- und Rechtsanwälte PartG mbB
(86) International application number: PCT/JP2016/078850
(87) International publication number: WO 2018/061151

(56) References cited:
- EP-A1- 3 061 331
- EP-B1- 3 061 331
- WO-A1-2014/080472
- WO-A1-2016/129105
- JP-A- 2010 129 718
- JP-A- 2010 272 657
- JP-A- 2015 076 529
- JP-B2- 3 567 897

## Description

### Technical Field

The present invention relates to a component mounting apparatus.

### Background Art

Conventionally, there is a known component mounting apparatus (for example, WO2014/80472A1) provided with a head main body, a suction nozzle that holds a component (electronic component), a first raising and lowering device for raising and lowering a raising and lowering member with respect to the head main body, and a second raising and lowering device for relatively raising and lowering the suction nozzle with respect to the raising and lowering member while being raised and lowered together with the raising and lowering member by the first raising and lowering drive device, and a load cell provided on the second raising and lowering device for detecting a load applied to the suction nozzle. The component mounting apparatus, when mounting a component held by the suction nozzle on a board, performs drive control of the first raising and lowering device to lower the suction nozzle, then performs drive control of the second raising and lowering device to lower the suction nozzle, and when the component held by the suction nozzle contacts the board, performs drive control of the second raising and lowering device such that a load (reaction force) applied to the suction nozzle is a predetermined set load.

Another component mounting apparatus having a first and a second raising and lowering device for a component holding member as well as a load measuring section is disclosed by the document EP3061331A1.

### Summary of Invention

### Technical Problem

The second raising and lowering device has a shorter raising and lowering stroke than the first raising and lowering device. Therefore, the component mounting apparatus measures the board height in advance, and before starting to drive the second raising and lowering device, controls the first raising and lowering device such that the suction nozzle is lowered to a target position that is a height of the suction nozzle immediately before the component held by the suction nozzle contacts the board on which the component is to be mounted. However, with the component mounting apparatus above, for example, if there is a tolerance included in the measured height of the board, or if the height of the board on which the component is to be mounted varies due to warping in a portion of the board, there are cases in which the raising and lowering stroke of the second raising and lowering device will be insufficient even if the suction nozzle is lowered to the target position by the first raising and lowering device. In this case, mounting defects may occur such as that the component held by the suction nozzle may not contact the board, or the pushing load of the component on the board may be insufficient.

An object of the present invention is to curtail the occurrence of mounting defects for components being mounted on a target object.

### Solution to Problem

The present invention uses the following means to achieve the above object.

A first component mounting apparatus of the present invention as defined in independent claim 1 is for holding a component and mounting the component on a target object, the component mounting apparatus including:
a holding member configured to hold a component;
a head;
a first raising and lowering device configured to raise and lower a raising and lowering member with respect to the head;
a second raising and lowering device, with a raising and lowering stroke shorter than a raising and lowering stroke of the first raising and lowering device, configured to relatively raise and lower the holding member with respect to the raising and lowering member;
a load measuring section configured to measure a load applied to the holding member; and
a control device configured to, when mounting the component held by the holding member on the target object, perform raising and lowering control of performing drive control of the first raising and lowering device to lower the holding member to a target position, and performing drive control of the second raising and lowering device to further lower the holding member such that a load measured by the load measuring section is a target load, and then perform releasing of holding of the component by the holding member, wherein
the control section, when the raising and lowering stroke of the second raising and lowering device has reached a stroke end before the component held by the holding member contacts the target object, changes the target position, performs raising and lowering control again, and releases the holding of the component by the holding member.

The first component mounting apparatus of the present invention, when mounting a component held by the holding member on a target object, performs drive control of the first raising and lowering member to lower the holding member to the target position, then performs drive control of the second raising and lowering device to further lower the holding member such that the load measured by the load measuring section is the target load, then releases the holding of the component by the holding member. Further, the first component mounting apparatus, when the raising and lowering stroke of the second raising and lowering device has reached a stroke end before the component held by the holding member contacts the target object, changes the target position, performs raising and lowering control again, and releases the holding of the component by the holding member. In this manner, even in a case in which the component held by the holding member does not reach the target object due to the raising and lowering stroke of the second raising and lowering device, it is possible to appropriately mount the component after making the component arrive at the target object by performing raising and lowering control again with a changed target position for the first raising and lowering device. As a result, it is possible to curtail the occurrence of mounting defects when mounting components on a target object.

A second component mounting apparatus of the present invention as defined in independent claim 2 is for holding a component and mounting the component on a target object, the component mounting apparatus including:
a holding member configured to hold a component;
a head;
a first raising and lowering device configured to raise and lower a raising and lowering member with respect to the head;
a second raising and lowering device, with a raising and lowering stroke shorter than a raising and lowering stroke of the first raising and lowering device, configured to relatively raise and lower the holding member with respect to the raising and lowering member;
a load measuring section configured to measure a load applied to the holding member; and
a control device configured to, when mounting the component held by the holding member on the target object, perform raising and lowering control of performing drive control of the first raising and lowering device to lower the holding member to a target position, and performing drive control of the second raising and lowering device to further lower the holding member such that a load measured by the load measuring section is a target load, and then perform releasing of holding of the component by the holding member, wherein the control section, when the raising and lowering stroke of the second raising and lowering device has reached a stroke end before the load measured by the load measuring section has reached the target load after the component held by the holding member has contacted the target object, after releasing the holding of the component by the holding member, changes the target position, and performs raising and lowering control again to apply pressure to the component again using the holding member.

The second component mounting apparatus of the present invention, when mounting a component held by the holding member on a target object, performs drive control of the first raising and lowering member to lower the holding member to the target position, then performs drive control of the second raising and lowering device to further lower the holding member such that the load measured by the load measuring section is the target load, then releases the holding of the component by the holding member. Further, the second component mounting apparatus, when the raising and lowering stroke of the second raising and lowering device has reached a stroke end before the load measured by the load measuring section has reached the target load after the component held by the holding member contacts the target object, after releasing the holding of the component by the holding member, changes the target position, and performs raising and lowering control again to apply pressure to the component again using the holding member. In this manner, even in a case in which the pushing load of the component held by the holding member pushing on the target object is insufficient due to the raising and lowering stroke of the second raising and lowering device, it is possible for the component to push the target object with an appropriate load by performing raising and lowering control again with a changed target position for the first raising and lowering device. As a result, it is possible to curtail the occurrence of mounting defects when mounting components on a target object.

With a component mounting apparatus of the present invention, the control section may, as the raising and lowering control, after performing drive control of the first raising and lowering device such that the holding member has been lowered to the target position, stop the driving of the first raising and lowering device, then perform drive control of the second raising and lowering member to further lower the holding member such that the load measured by the load measuring section is the target load. Thus, it is possible to improve control of the second raising and lowering device.

Further, with a component mounting apparatus of the present invention, the control section may determine whether the component held by the holding member has contacted the target object based on the load measured by the load measuring section.

### Brief Description of Drawings

Fig. 1

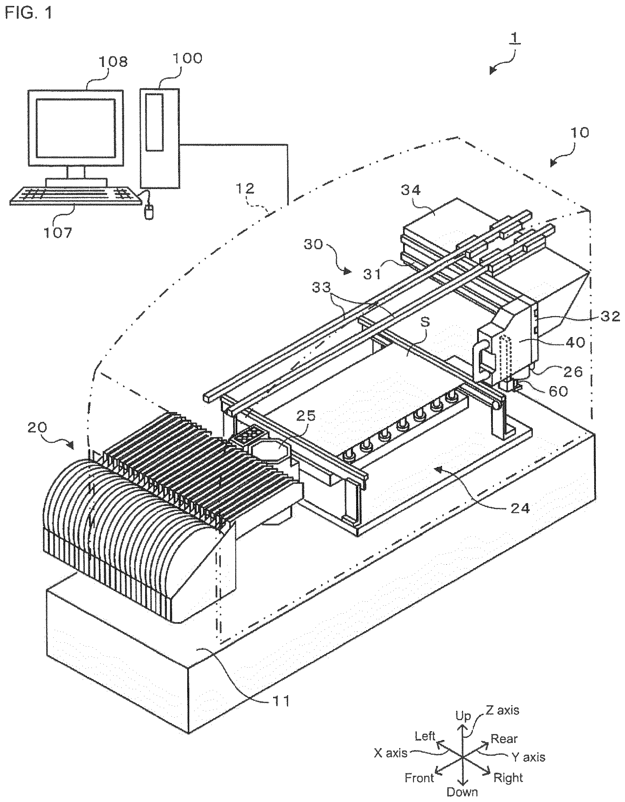

   Fig. 1 shows an outline of the configuration of component mounting system 1 that includes component mounting apparatus 10 of an embodiment.
Fig. 2

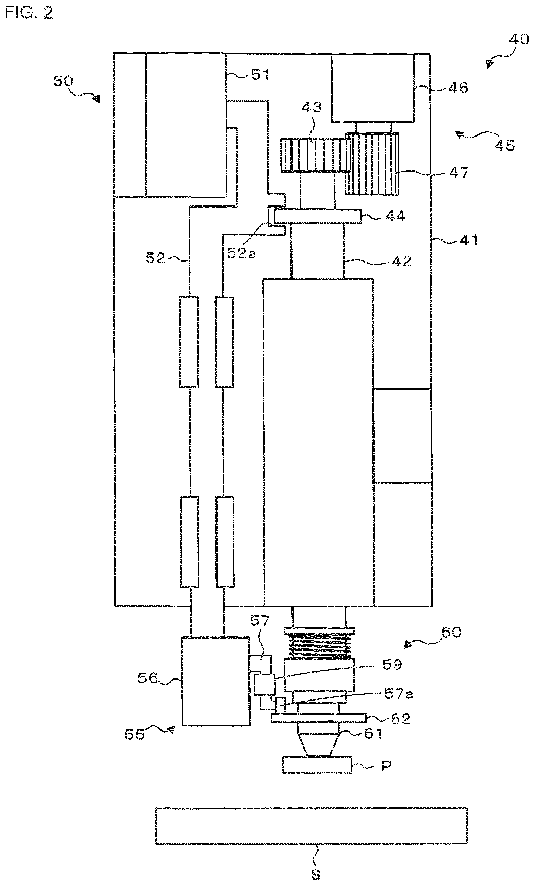

   Fig. 2 shows an outline of the configuration of mounting head 40.
Fig. 3

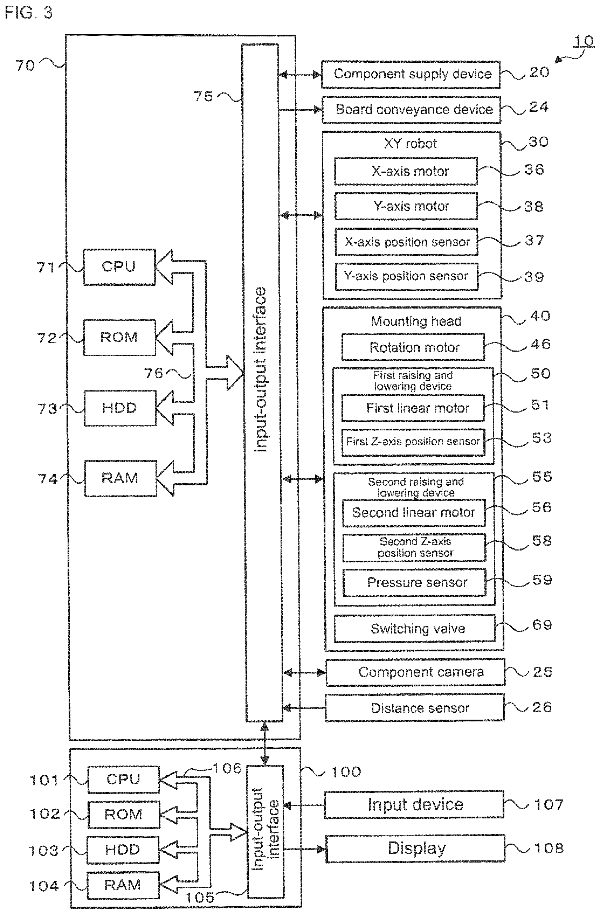

   Fig. 3 is a block diagram showing the electrical connections of control device 70.
Fig. 4

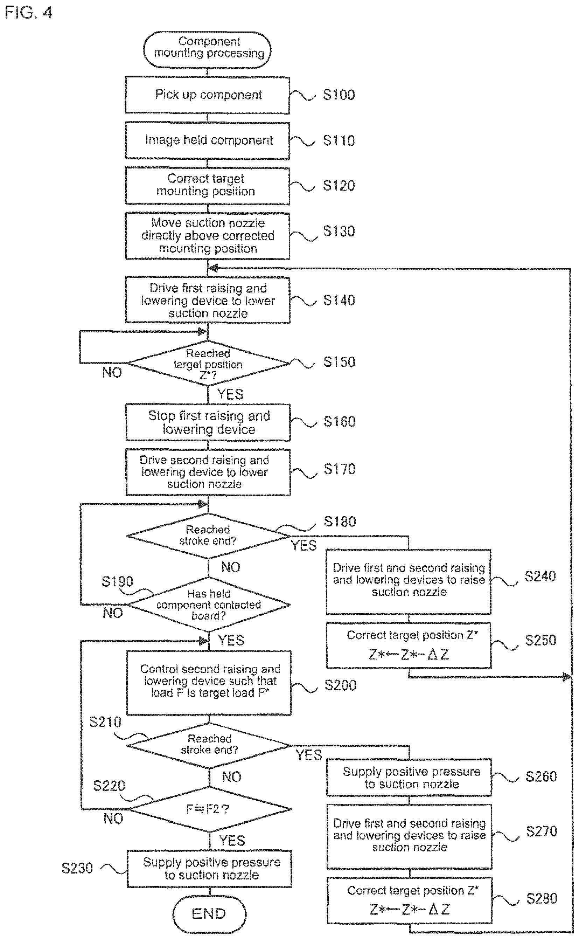

   Fig. 4 is a flowchart showing an example of component mounting processing.
Fig. 5

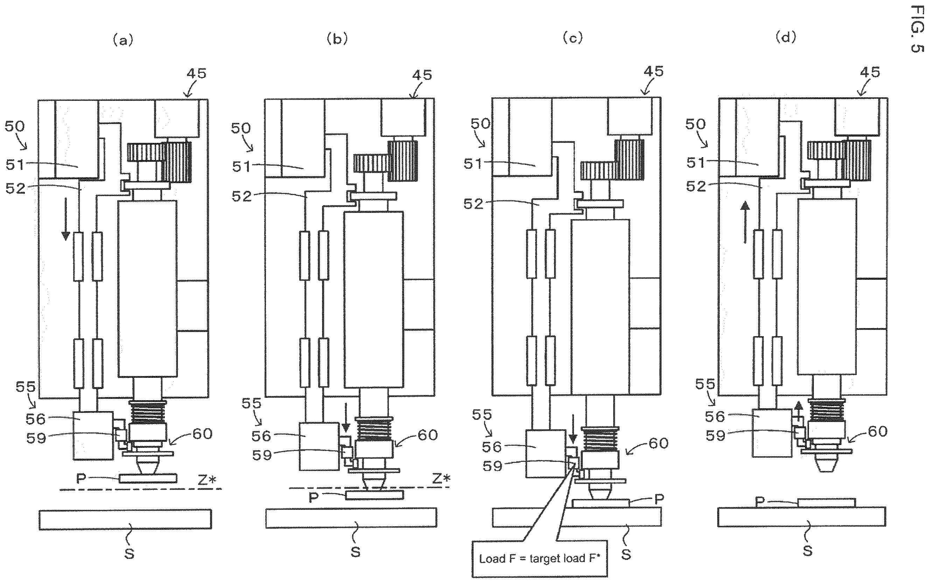

   Fig. 5 illustrates states of mounting operation using first raising and lowering device 50 and second raising and lowering device 55.
Fig. 6

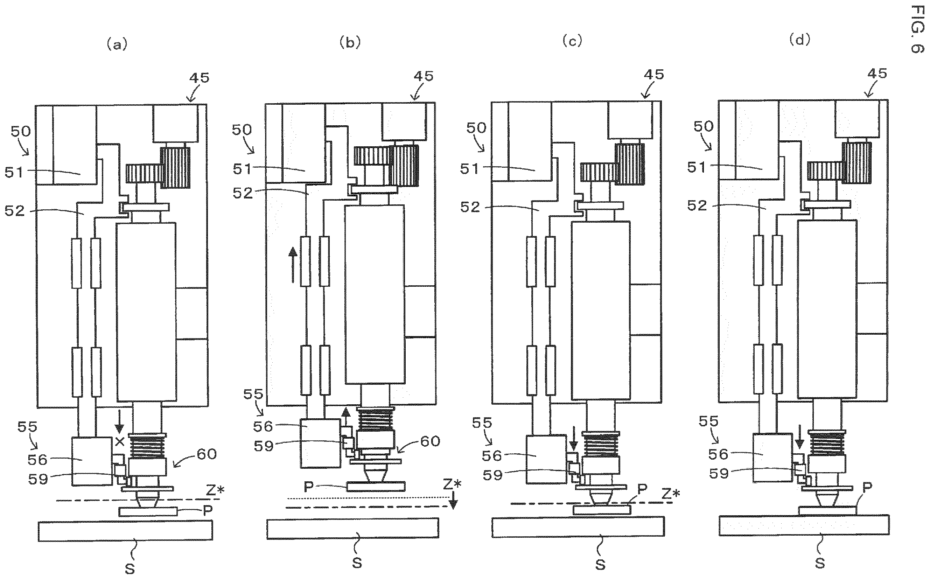

   Fig. 6 illustrates states of mounting operation during midair mounting.
Fig. 7

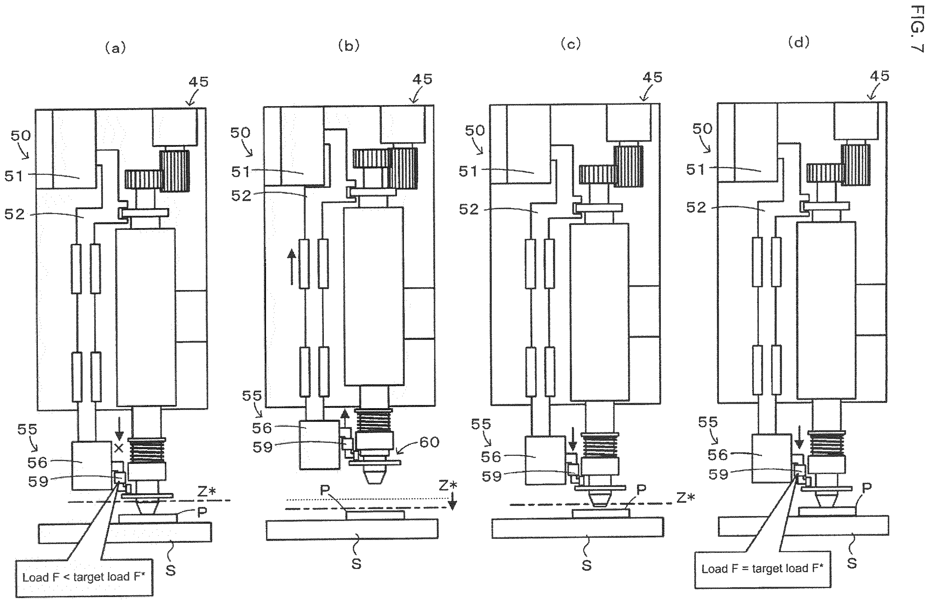

   Fig. 7 illustrates states of mounting operation when the load is insufficient.

### Description of Embodiments

Embodiments of the present invention are described below with reference to the drawings.

Fig. 1 shows an outline of the configuration of component mounting system 1 that includes component mounting apparatus 10 of an embodiment; fig. 2 shows an outline of the configuration of mounting head 40; and fig. 3 is a block diagram showing the electrical connections of control device 70. Note that, the left-right direction in fig. 1 is the X-axis direction, the front-rear direction is the Y-axis direction, and the up-down direction is Z-axis direction.

As shown in fig. 1, component mounting system 1 is provided with component mounting apparatus 10 and management device 100 that manages component mounting apparatus 10. In component mounting system 10, multiple component mounting apparatuses 10 that mount components on board S are arranged in a line from upstream to downstream. For convenience of description, fig. 1 only shows one component mounting apparatus 10. Note that, component mounting system 10 may also be provided with items such as a solder printer, inspection machine, and reflow oven in the same mounting line as component mounting apparatus 10.

As shown in fig. 1, component mounting apparatus 10 is provided with component supply device 20 that supplies components P to a component supply position, board conveyance device 24 that conveys board S, mounting head 40 that picks up (collects) a component P supplied to the component supply position and mounts the component on board S (target object), XY robot 30 that moves mounting head 40 in the XY axis directions, and control device 70 (refer to fig. 3) that performs overall device control. Board conveyance device 24 is provided on base 11 and component supply device 20 is removably provided on base 11. Component mounting apparatus 10 is also provided with items such as component camera 25 for imaging from below component P held by suction nozzle 60, a mark camera (not shown) attached to mounting head 40 for imaging from above positioning reference marks provided on board S, and distance sensor 26 (such as an infrared sensor) attached to mounting head 40 and for measuring the height (the position in the Z-axis direction of the upper surface of board S).

Component supply device 20 is configured from tape feeders that supply components P to a component supply device by pitch feeding, from a reel, tape that houses components P in storage sections formed at regular intervals.

As shown in fig. 1, XY robot 30 is provided with Y-axis guide rail 33 attached to an upper level of housing 12 extending in the front-rear direction (Y direction), Y-axis slider 34 that is able to slide along Y-axis guide rail 33 while being supported on Y-axis guide rail 33, X-axis guide rail 31 attached to a side surface of Y-axis slider 34 extending in the left-right direction (X direction), and X-axis slider 32 that is able to slide along X-axis guide rail 31. X-axis slider 32 is movable by the driving of X-axis motor 36 (refer to fig. 3), and Y-axis slider 34 is movable by the driving of Y-axis motor 38 (refer to fig. 3). Mounting head 40 is provided on X-axis slider 32, and control device 70 moves mounting head 40 in an XY directions by performing drive control of XY robot 30 (X-axis motor 36 and Y-axis motor 38).

As shown in fig. 2, mounting head 40 is provided with: head main body 41; suction nozzle 60; nozzle holder 42 provided to be movable in an up-down direction (Z-axis direction) with respect to head main body 41 and to which suction nozzle 60 is removable attached; rotation device 45 that rotates nozzle holder 42; first raising and lowering device 50 that raises and lowers first Z-axis slider 52 in a Z-axis direction with respect to head main body 41; and second raising and lowering device 55 provided on first Z-axis slider 52 and that raises and lowers suction 60 nozzle relatively in the Z-axis direction with respect to first Z-axis slider 52.

Suction nozzle 60 is attached to be movable in an up-down direction (Z-axis direction) with respect to nozzle holder 42. A compression spring, not shown, is built into nozzle holder 42 and suction nozzle 60 is biased upwards with respect to nozzle holder 42 by the biasing force of the compression spring. Suction nozzle 60 is provided with suction section 61 that is capable of picking up component P by negative pressure being applied to a suction opening at the end of suction section 61 and the suction opening contacting against component P, and flange section 62 extending in a diameter direction at an upper section of suction section 61. Suction section 61 is connected to a negative pressure source and positive pressure source, which are not shown, via switching valve 69 (refer to fig. 3), and, by connecting to the negative pressure source using switching valve 69, negative pressure is supplied at the suction opening of suction section 61 to pick up component P, and, by connecting to the positive pressure source using switching valve 69, positive pressure is supplied at the suction opening of suction section 61 to release component P.

Rotation device 45 is provided with rotation motor 46 a rotating shaft of which is provided with gear 47. Gear 43 that engages with gear 47 is attached to an upper end of nozzle holder 42, and by control device 70 performing drive control of rotation motor 46, rotation device 45 can adjust nozzle holder 42 to any rotation angle. As described above, because suction nozzle 60 is attached to an end of nozzle holder 42, by rotation device 45 adjusting the rotation angle of nozzle holder 42, the rotation angle of component P held by suction nozzle 60 can be adjusted.

As shown in fig. 2, first raising and lowering device 50 is provided with first linear motor 51, and first Z-axis slider 52 that can be raised and lowered in the Z-axis direction by the driving of first linear motor 51. First engaging section 52a that can engage with (contact) horizontal section 44 provided on nozzle holder 42 is formed on first Z-axis slider 52. Therefore, nozzle holder 42 can be raised and lowered in accordance with the raising and lowering of first Z-axis slider 52. Because suction nozzle 60 is attached to nozzle holder 42, first raising and lowering device 50 can raise and lower suction nozzle 60 in accordance with the raising and lowering of nozzle holder 42.

As shown in fig. 2, second raising and lowering device 55 is provided with second linear motor 56 attached to first Z-axis slider 52 of first raising and lowering device 50, and second Z-axis slider 57 that can be raised and lowered by the driving of second linear motor 56. Second engaging section 57a that can engage with (contact) an upper surface of flange section 62 of suction nozzle 60 is formed on second Z-axis slider 57. Therefore, suction nozzle 60 can be raised and lowered in accordance with the raising and lowering of second Z-axis slider 57. In the present embodiment, the stroke distance of second Z-axis slider 57 by second raising and lowering device 55 is shorter than the stroke distance of first Z-axis slider 52 by first raising and lowering device 50. Mounting head 40, after rough adjustment of the Z-axis position of component P held by suction nozzle 60 by first raising and lowering device 50, can perform fine adjustment of the Z-axis position of component P using second raising and lowering device 55. Also, pressure sensor 59 for detecting load F applied to suction nozzle 60 when component P contacts suction section 61 of suction nozzle 60 during pickup and when component P held by suction nozzle 60 contacts board S during mounting is provided on second Z-axis slider 57.

As shown in fig. 3, control device 70 is provided with CPU 71, ROM 72, HDD 73, RAM 74, and input-output interface 75. These items are electrically connected by bus 76. Image signals from component camera 25, image signals from the mark camera, detection signals from distance sensor 26, load F from pressure sensor 59, detection signals from X-axis position sensor 37 for detecting the position of X-axis slider 32 in the X-axis direction, detection signals of Y-axis position sensor 39 for detecting the position of Y-axis slider 34 in the Y-axis direction, detection signals of first Z-axis position sensor 53 for detecting the position of first Z-axis slider 52 in the Z-axis direction, detection signals of second Z-axis position sensor 58 for detecting the position of second Z-axis slider 57 in the Z-axis direction, and so on enter control device 70 via input-output interface 75. On the other hand, control signals for component supply device 20, control signals for board conveyance device 24, drive signals for XY robot 30 (X-axis motor 36 and Y-axis motor 38), drive signals for mounting head 40 (rotation motor 46, first linear motor 51, second linear motor 56, switching valve 69, and so on), and so on are output from control device 70 via an output port. Also, control device 70 is connected to management device 100 such that two-way communication is possible, and they perform communication of data and control signals with each other.

Management device 100, for example, is a general purpose computer provided with, as shown in fig. 3, items such as CPU 101, ROM 102, HDD 103, RAM 104, and input-output interface 105. These items are electrically connected by bus 106. Management computer 100 receives input signals from input device 107 such as a mouse or keyboard via input-output interface 105. Also, management device 100 outputs image signals to display 108 via input-output interface 105. HDD 103 memorizes job information. Job information, for example, includes the types of components P to be mounted, the mounting order, the mounting positions, the types of the mounting head 40 and suction nozzle 60 to be used, and so on.

Next, operation of the embodiment of component mounting apparatus 10 configured as above is described. Fig. 4 is a flowchart illustrating an example of component mounting processing performed by CPU 71 of control device 70. This processing is performed when job information is received according to production instructions from management device 100.

In the component mounting processing, CPU 71 of control device 70, first, causes suction nozzle 60 to pick up component P supplied by component supply device 20 (step S100). This processing is performed by performing drive control of XY robot 30 to move suction nozzle 60 directly above the component supply position, then performing drive control of first raising and lowering device 50 to lower suction nozzle 60 at high speed, then, directly before suction nozzle 60 contacts component P, performing drive control of second raising and lowering device 55 to lower suction nozzle 60 at low speed, then performing drive control of switching valve 69 to supply negative pressure to pickup section 61. Continuing, CPU 71 performs drive control of XY robot 30 such that suction nozzle 60 passes above component camera 25, and uses component camera 25 to capture an image from below of component P held by suction nozzle 60 (step S110). Then, CPU 71 processes the captured image and corrects the mounting position on board S (step S120), and performs drive control of XY robot 30 to move suction nozzle 60 directly above the mounting position (step S130). Next, CPU 71 performs drive control of first raising and lowering device 50 to lower suction nozzle 60 at high speed (step S140), then determines whether the position of suction nozzle 60 in the Z-axis direction identified based on signals from first Z-position sensor 53 and second Z-position sensor 58 has reached target position Z* (step S150). Here, target position Z* is set as a position a specified distance, based on the stroke amount of second raising and lowering device 55 with a margin reduced, from the height of the upper surface of board S measured by distance sensor 26. CPU 71, if determining that the position of suction nozzle 60 has not reached target position Z*, continues lowering suction nozzle 60 using first raising and lowering device 50, and if determining that the position of suction nozzle 60 has reached target position Z*, stops driving first raising and lowering device 50 (step S160) and further lowers suction nozzle 60 at low speed by performing drive control of second raising and lowering device 55 (step S170).

Next, CPU 71 determines whether the raising and lowering stroke of second raising and lowering device 55 has reached the stroke end (step S180), and determines whether component P held by suction nozzle 60 has contacted board S (step S190). Here, the determination of step S180 is performed by determining whether the position of second Z-axis slider 57 in the Z-axis direction detected by second Z-axis position sensor 58 has reached a position corresponding to a stroke end. Also, the determination of step S190 is performed by determining whether load F applied to suction nozzle 60 detected by pressure sensor 59 has reached the specified load corresponding to contact with board S. CPU 71, upon determining that component P held by suction nozzle 60 has contacted board S before the raising and lowering stroke of second raising and lowering device 55 reaches the stroke end, performs drive control of second raising and lowering device 55 using feedback control such that load F applied to suction nozzle 60 is target load F*. Here, target load F* is determined in advance as an appropriate pushing load for mounting component P on board S. Further, CPU 71 determines whether the raising and lowering stroke of second raising and lowering device 55 has reached the stroke end (step S210), and determines whether load F applied to suction nozzle 60 is substantially equal to target load F* (step S220). CPU 71, upon determining that load F applied to suction nozzle 60 is substantially equal to target load F* before the raising and lowering stroke of second raising and lowering device 55 has reached the stroke end, mounts the component P on board S by performing drive control of switching valve 69 to supply positive pressure to suction nozzle 60 (step S230), then ends component mounting processing.

CPU 71, upon determining in steps S180 and S190 that the raising and lowering stroke of second raising and lowering device 55 has reached the stroke end before component P held by suction nozzle 60 has contacted board S, determines that the raising and lowering stroke of second raising and lowering device 55 is insufficient and that component P was mounted in midair without reaching board S. In this case, CPU 71, first, performs drive control of first raising and lowering device 50 and second raising and lowering device 55 to raise suction nozzle 60 (step S240). Next, CPU 71 corrects target position Z* by lowering target position Z* of first raising and lowering device 50 by exactly specified amount ΔZ (step S250), then returns to step S140. That is, CPU 71 performs drive control of first raising and lowering device 50 to lower suction nozzle 60 again to the corrected target position Z* (steps S140, S150). CPU 71, upon determining that suction nozzle 60 has reached the corrected target position Z*, stops driving of first raising and lowering device 50, performs drive control of second raising and lowering device 55 to further lower suction nozzle 60 until component P held by suction nozzle 60 contacts board S (steps S160 to S190). Here, CPU 71, if determining that the raising and lowering stroke of second raising and lowering device 55 has reached the stroke end without component P contacting board S even after target position Z* was corrected, raises suction nozzle 60 again, lowers target position Z* by exactly the specified amount ΔZ (steps S240, S250), then repeats processing of steps S140 to S190. CPU 71, if determining in steps S180 and S190 that component P has contacted board S without the raising and lowering stroke of second raising and lowering device 55 reaching the stroke end, performs processing from step S200. As described above, target position Z* is set as a position a specified distance, based on the stroke amount of second raising and lowering device 55 with a margin reduced, from the height of the upper surface of board S measured by distance sensor 26. Therefore, usually, if driving of second raising and lowering device 55 is started after suction nozzle 60 has arrived at target position S*, it should be possible to contact board S with component P held by suction nozzle 60 and to push the component P into the board S so as to mount the component. However, if there is a tolerance in the height of board S detected by distance sensor 26, or if the height of the board S varies due to warping in a portion of the board S, the raising and lowering stroke of second raising and lowering device 55 will be insufficient, meaning that component P may not reach board S, or component P will not be pushed onto board S with an appropriate load. Here, CPU 71, in a case in which component P does not reach board S, raises suction nozzle 60 with the component P still held by the suction nozzle 60, corrects target position Z* by lowering target position Z* of first raising and lowering device 50 by exactly specified amount ΔZ, lowers suction nozzle 60 to the corrected target position Z* using first raising and lowering device 50 and then performs driving of second raising and lowering device 55. By this, component mounting apparatus 10 resolves the insufficient stroke of second raising and lowering device 55 and mounts the component P on the board S by appropriately contacting board S with the component P.

CPU 71, upon determining in steps S180 and S190 that the raising and lowering stroke of second raising and lowering device 55 has reached the stroke end before load F applied to suction nozzle 60 has reached target load F*, determines that the raising and lowering stroke of second raising and lowering device 55 is insufficient and that the load with which component P was pushed onto board S was insufficient (load insufficiency). In this case, CPU 71, first, performs drive control of switching valve 69 to supply positive pressure to suction nozzle 60 so as to release the holding of the component P by suction nozzle 60 in a state with an insufficient load, thereby mounting the component P on board S (step S260). Then, CPU 71 performs drive control of first raising and lowering device 50 and second raising and lowering device 55 to raise only suction nozzle 60 (step S270). Next, CPU 71 corrects target position Z* by lowering target position Z* of first raising and lowering device 50 by exactly specified amount ΔZ (step S280), then returns to step S140. Here, specified amount ΔZ is the same as the specified amount ΔZ used in step S250 described above. Note that, specified amount ΔZ may be set to lower target position Z* by a larger amount the larger the difference between load F detected by pressure sensor 59 and target load F* (load insufficiency amount). CPU 71 performs drive control of first raising and lowering device 50 to lower suction nozzle 60 again to the corrected target position Z* (steps S140, S150). CPU 71, upon determining that suction nozzle 60 has reached the corrected target position Z*, stops driving of first raising and lowering device 50, performs drive control of second raising and lowering device 55 to further lower suction nozzle 60 until component P held by suction nozzle 60 contacts board S (steps S160 to S190). CPU 71, upon determining that component P has contacted board S in step S190, performs drive control of second raising and lowering device 55 until the load F applied to suction nozzle 60 is substantially equal to target load F* (S200 to S220). Here, CPU 71, if determining again that the raising and lowering stroke of second raising and lowering device 55 has reached the stroke end before load F was substantially equal to target load F*, raises suction nozzle 60 again, further lowers target position Z* by exactly the specified amount ΔZ (steps S260 to S280), then repeats processing of steps S140 to S220. Further, CPU 71, upon determining that the load F applied to suction nozzle 60 has reached target load F* without the raising and lowering stroke of second raising and lowering device 55 reaching the stroke end, supplies positive pressure to suction nozzle 60 (step S230), then ends component mounting processing. In a case in which the component P held by suction nozzle 60 contacts board S but the raising and lowering stroke of second raising and lowering device 55 is insufficient such that the load with which component P is pushed onto board S is insufficient, it can be considered that solder will already be on component P due to component P having contacted board S. Here, CPU 71, raises suction nozzle 60 only after having released the holding of the component P by the suction nozzle 60, corrects target position Z* by lowering target position Z* of first raising and lowering device 50 by exactly specified amount ΔZ, lowers suction nozzle 60 to the corrected target position Z* using first raising and lowering device 50 and then performs driving of second raising and lowering device 55. By this, component mounting apparatus 10 resolves the insufficient stroke of second raising and lowering device 55, and contacts suction nozzle 60 against component P so as to apply pressure again to the component P with suction nozzle 60 until target load F* is reached.

Fig. 5 illustrates states of mounting operation using first raising and lowering device 50 and second raising and lowering device 55. CPU 71 lowers suction nozzle 60 at high speed using first raising and lowering device 50 until the tip of suction nozzle 60 reaches target position Z* (refer to fig. 5[a]), then, after the tip of suction nozzle 60 has reached target position Z*, lowers suction nozzle 60 at low speed using second raising and lowering device 55 (refer to fig. 5[b]). By this, the impact force with which component P held by suction nozzle 60 contacts board S is softened. Further, CPU 71, when component P contacts board S, after performing drive control of second raising and lowering device 55 such that load F with which component P pushes board S becomes target load F* (refer to fig. 5[c]), releases the holding of the component P by suction nozzle 60 so as to mount the component P on board S (refer to fig. 5[d]).

Fig. 6 illustrates states of mounting operation during midair mounting. CPU 71, after lowering suction nozzle 60 to target position Z* by driving first raising and lowering device 50, in a case in which the raising and lowering stroke when driving second raising and lowering device 55 was insufficient and component P did not reach board S (refer to fig. 6[a]), raises suction nozzle 60 still holding component P and lowers the target position Z* of first raising and lowering device 50 (refer to fig. 6[b]). Further, CPU 71 lowers suction nozzle 60 to the lowered target position Z* using first raising and lowering device 50, further lowers the suction nozzle 60 from there using second raising and lowering device 55, and contacts component P on board S to mount component P (refer to figs. 6[c] and 6[d]).

Fig. 7 illustrates states of mounting operation when the load is insufficient. In a case in which, after lowering suction nozzle 60 to target position Z* by driving first raising and lowering device 50, CPU 71 contacted component P on board S by driving second raising and lowering device 55, but the raising and lowering stroke of second raising and lowering device 55 was insufficient, and the load with which component P pushed board S did not reach target load F* (refer to fig. 7[a]), CPU 71 releases the holding of component P by suction nozzle 60 to mount the component P Next, CPU 71 raises only suction nozzle 60 and then lowers the target position Z* of first raising and lowering device 50 (refer to fig. 7[b]). Further, CPU 71 lowers suction nozzle 60 to the lowered target position Z* using first raising and lowering device 50, further lowers the suction nozzle 60 from there using second raising and lowering device 55, and contacts suction nozzle 60 on component P mounted on board S to apply pressure to the component P (refer to figs. 7[c] and 7[d]).

Correspondences between main constituent elements of the embodiments and main constituent elements of the invention will be clarified here. Suction nozzle 60 corresponds to a "holding member", mounting head 40 corresponds to a "head", first raising and lowering device 50 corresponds to a "first raising and lowering device", second raising and lowering device 55 corresponds to a "second raising and lowering device", pressure sensor 59 corresponds to a "load measuring section", and control device 70 corresponds to a "control device".

Component mounting apparatus 10 of an embodiment described above is provided with, as a raising and lowering device to raise and lower suction nozzle 60, first raising and lowering device 50, second raising and lowering device 55 with a raising and lowering stroke shorter than that of first raising and lowering device 50, and pressure sensor 59 for detecting a load applied to suction nozzle 60. Component mounting apparatus 10, when mounting a component P held by suction nozzle 60 on board S, lowers suction nozzle 60 to target position Z* using first raising and lowering device 50, further lowers suction nozzle 60 using second raising and lowering device 55 such that component P contacts board S, and controls second raising and lowering device 55 such that load F applied to suction nozzle 60 becomes target load F* to mount component P on board S. Also, component mounting apparatus 10, in a case in which the raising and lowering stroke of second raising and lowering device 55 is insufficient and component P does not reach board S, raises suction nozzle 60 that is still holding component P and corrects target position Z*, then lowers suction nozzle 60 to the corrected target position Z* using first raising and lowering device 51, and further lowers suction nozzle 60 using second raising and lowering device 55 to contact component P on board S so as to mount component P. By this, component mounting apparatus 10, even in a case in which there is an error included in distance sensor 26, or the height of board S varies due to warping in a portion of the board S, the stroke insufficiency of second raising and lowering device 55 can be resolved, and the component P held by suction nozzle 60 can be more reliably contacted against and mounted on board S. As a result, releasing the holding of component P by suction nozzle 60 in a state in which component P is not contacting board S is prevented, and the occurrence of mounting defects when mounting components P on board S can be curtailed.

Also, component mounting apparatus 10, in a case in which component P contacts board S but the raising and lowering stroke of second raising and lowering device 55 is insufficient such that the load with which component P pushes board S does not reach target load Z*, first, releases the holding of component P by suction nozzle 60 to mount the component P on board S. Further, component mounting apparatus 10 raises suction nozzle 60 only, corrects target position Z*, lowers suction nozzle 60 to the corrected target position Z* using first raising and lowering device 50, then further lowers suction nozzle 60 using second raising and lowering device 55 to apply pressure to component P again using suction nozzle 60 until reaching target load Z*. By this, even in a case in which there is an error included in distance sensor 26, or the height of board S varies due to warping in a portion of the board S, the stroke insufficiency of second raising and lowering device 55 can be resolved, and component P can be more reliably contacted against and mounted on board S. As a result, it is possible to curtail the occurrence of mounting defects when mounting components P on board S.

Meanwhile, it goes without saying that the invention is not limited to the above-mentioned embodiment and various embodiments may be applied within the scope of the appended claims.

For example, in an embodiment above, CPU 71, when lowering suction nozzle 60 by driving second raising and lowering device 55 (second linear motor 56), stops driving of first raising and lowering device 50 (first linear motor 51) then starts driving of second raising and lowering device 55, but driving of second raising and lowering device 55 may be started while first raising and lowering device 50 is being driven.

Also, in an embodiment above, with component mounting apparatus 10, distance sensor 26 for measuring the height of the upper surface of board S is provided on head 40, but board S may be imaged using a mark camera and the height of the upper surface of board S measured by comparing the captured image with an image of the board that was captured at a predetermined reference height.

Further, in an embodiment above, the load applied on suction nozzle 60 is detected using pressure sensor 59 provided on second Z-axis slider 57, but the load applied on suction nozzle 60 may be measured by detecting or estimating the electrical current load on second linear motor 56.

Also, in an embodiment above, first linear motor 51 is used as an actuator for first raising and lowering device 50, but a voice coil motor, ball screw mechanism, or the like may be used. Also, in an embodiment above, second linear motor 56 is used as an actuator for second raising and lowering device 55, but a voice coil motor or the like may be used.

### Industrial Applicability

The present invention may be applied to the industrial field of component mounting apparatuses and the like.

### Reference Signs List

1: component mounting system;
10: component mounting apparatus;
11: base;
12: housing;
20: component supply device;
24: board conveyance device;
25: component camera;
26: distance sensor;
30: XY robot;
31: X-axis guide rail;
32: X-axis slider;
33: Y-axis guide rail;
34: Y-axis slider;
36: X-axis motor;
37: X-axis position sensor;
38: Y-axis motor;
39: Y-axis position sensor;
40: mounting head;
41: head main body;
42: nozzle holder;
43: gear;
44: horizontal section;
45: rotation device;
46: rotation motor;
47: gear;
50: first raising and lowering device;
51: first linear motor;
52: first Z-axis slider;
52a: first engaging section;
53: first Z-axis position sensor;
55: second raising and lowering device;
56: second linear motor;
57: second Z-axis slider;
57a: second engaging section;
58: second Z-axis position sensor;
59: pressure sensor;
60: suction nozzle;
61: pickup section;
62: flange section;
69: switching valve;
70: control device;
71 CPU;
72 ROM;
73 HDD;
74 RAM;
75: input-output interface;
76: bus;
100: management device;
101 CPU;
102 ROM;
103 HDD;
104 RAM;
105: input-output interface;
106: bus;
107: input device;
108: display;
P: component;
S: board

## Claims

1. A component mounting apparatus (10) for holding a component (P) and mounting the component (P) on a target object (S), the component mounting apparatus (10) comprising:
a holding member (60) configured to hold a component (P);
a head (40);
a first raising and lowering device (50) configured to raise and lower a raising and lowering member (52) with respect to the head (40);
a second raising and lowering device (55), with a raising and lowering stroke shorter than a raising and lowering stroke of the first raising and lowering device (50), configured to relatively raise and lower the holding member (60) with respect to the raising and lowering member (52);
a load measuring section (59) configured to measure a load applied to the holding member (60); and
a control device (70) configured to, when mounting the component (P) held by the holding member (60) on the target object (S), perform raising and lowering control of performing drive control of the first raising and lowering device (50) to lower the holding member (60) to a target position, and performing drive control of the second raising and lowering device (55) to further lower the holding member (60) such that a load measured by the load measuring section (59) is a target load, and then perform releasing of holding of the component (P) by the holding member (60), wherein
the control device (70) is configured to, when the raising and lowering stroke of the second raising and lowering device (55) has reached a stroke end before the component (P) held by the holding member (60) contacts the target object (S), change the target position, perform raising and lowering control again, and release the holding of the component (P) by the holding member (60).

2. A component mounting apparatus (10) for holding a component (P) and mounting the component (P) on a target object (S), the component mounting apparatus (10) comprising:
a holding member (60) configured to hold a component (P);
a head (40);
a first raising and lowering device (50) configured to raise and lower a raising and lowering member (52) with respect to the head (40);
a second raising and lowering device (55), with a raising and lowering stroke shorter than a raising and lowering stroke of the first raising and lowering device (50), configured to relatively raise and lower the holding member (60) with respect to the raising and lowering member (52);
a load measuring section (59) configured to measure a load applied to the holding member (60); and
a control device (70) configured to, when mounting the component (P) held by the holding member (60) on the target object (S), perform raising and lowering control of performing drive control of the first raising and lowering device (50) to lower the holding member (60) to a target position, and performing drive control of the second raising and lowering device (55) to further lower the holding member (60) such that a load measured by the load measuring section (70) is a target load, and then perform releasing of holding of the component (P) by the holding member (60), wherein
the control device (70) is configured to, when the raising and lowering stroke of the second raising and lowering device (55) has reached a stroke end before the load measured by the load measuring section (59) has reached the target load after the component (P) held by the holding member (60) has contacted the target object (S), after releasing the holding of the component (P) by the holding member (60), change the target position, and perform raising and lowering control again to apply pressure to the component again using the holding member (60).

3. The component mounting apparatus according to claim 1 or 2, wherein
the control device (70) is configured to, as the raising and lowering control, after performing drive control of the first raising and lowering device (50) such that the holding member (60) has been lowered to the target position, stop the driving of the first raising and lowering device (50), then perform drive control of the second raising and lowering member (55) to further lower the holding member (60) such that the load measured by the load measuring section (59) is the target load.

4. The component mounting apparatus according to any one of the claims 1 to 3, wherein
the control device (70) is configured to determine whether the component (P) held by the holding member (60) has contacted the target object (S) based on the load measured by the load measuring section (59).

## Patentansprüche

1. Vorrichtung (10) zum Montieren von Bauteilen, mit der ein Bauteil (P) gehalten wird und das Bauteil (P) an einem Zielobjekt (S) montiert wird, wobei die Vorrichtung (10) zum Montieren von Bauteilen umfasst:
ein Halteelement (60), das zum Halten eines Bauteils (P) ausgeführt ist;
einen Kopf (40);
eine erste Anhebe-und-Absenk-Einrichtung (50), die so ausgeführt ist, dass sie ein Anhebe-und-Absenk-Element (52) in Bezug auf den Kopf (40) anhebt und absenkt;
eine zweite Anhebe-und-Absenk-Einrichtung (55) mit einem Anhebe-und-Absenk-Hub, der kürzer ist als ein Anhebe-und-Absenk-Hub der ersten Anhebe-und-Absenk-Einrichtung (50), die so ausgeführt ist, dass sie das Halteelement (60) relativ zu der Anhebe-und-Absenk-Einrichtung (52) anhebt und absenkt;
einen Lastmessungs-Teilabschnitt (59), der so ausgeführt ist, dass er eine auf das Halteelement (60) wirkende Last misst; sowie
eine Steuerungseinrichtung (70), die so ausgeführt ist, dass sie, wenn sie das von dem Halteelement (60) gehaltene Bauteil (P) an dem Zielobjekt (S) montiert, Steuerung zum Anheben und Absenken durchführt, bei der sie Antriebssteuerung der ersten Anhebe-und-Absenk-Einrichtung (50) durchführt, um das Halteelement (60) an eine Zielposition abzusenken, und Antriebssteuerung der zweiten Anhebe-und-Absenk-Einrichtung (55) durchführt, um das Halteelement (60) weiter abzusenken, so dass eine von dem Lastmessungs-Teilabschnitt (59) gemessene Last eine Ziel-Last ist, und dann Lösen des Haltens des Bauteils (P) durch das Halteelement (60) durchführt, wobei
die Steuerungseinrichtung (70) so ausgeführt ist, dass sie, wenn der Anhebe-und-Absenk-Hub der zweiten Anhebe-und-Absenk-Einrichtung (55) ein Hub-Ende erreicht hat, bevor das von dem Halteelement (60) gehaltene Bauteil (P) mit dem Zielobjekt (S) in Kontakt kommt, die Zielposition ändert, erneut Steuerung zum Anheben und Absenken durchführt und ich Halten des Bauteils (P) durch das Halteelement (60) löst.

2. Vorrichtung (10) zum Montieren von Bauteilen, mit der ein Bauteil (P) gehalten wird und das Bauteil (P) an einem Zielobjekt (S) montiert wird, wobei die Vorrichtung (10) zum Montieren von Bauteilen umfasst:
ein Halteelement (60), das zum Halten eines Bauteils (P) ausgeführt ist;
einen Kopf (40);
eine erste Anhebe-und-Absenk-Einrichtung (50), die so ausgeführt ist, dass sie ein Anhebe-und-Absenk-Element (52) in Bezug auf den Kopf (40) anhebt und absenkt;
eine zweite Anhebe-und-Absenk-Einrichtung (55) mit einem Anhebe-und-Absenk-Hub, der kürzer ist als ein Anhebe-und-Absenk-Hub der ersten Anhebe-und-Absenk-Einrichtung (50), die so ausgeführt ist, dass sie das Halteelement (60) relativ zu der Anhebe-und-Absenk-Einrichtung (52) anhebt und absenkt;
einen Lastmessungs-Teilabschnitt (59), der so ausgeführt ist, dass er eine auf das Halteelement (60) wirkende Last misst; sowie
eine Steuerungseinrichtung (70), die so ausgeführt ist, dass sie, wenn sie das von dem Halteelement (60) gehaltene Bauteil (P) an dem Zielobjekt (S) montiert, Steuerung zum Anheben und Absenken durchführt, bei der sie Antriebssteuerung der ersten Anhebe-und-Absenk-Einrichtung (50) durchführt, um das Halteelement (60) an eine Zielposition abzusenken, und Antriebssteuerung der zweiten Anhebe-und-Absenk-Einrichtung (55) durchführt, um das Halteelement (60) weiter abzusenken, so dass eine von dem Lastmessungs-Teilabschnitt (70) gemessene Last eine Ziel-Last ist, und dann Lösen des Haltens des Bauteils (P) durch das Halteelement (60) durchführt, wobei
die Steuerungseinrichtung (70) so ausgeführt ist, dass sie, wenn der Anhebe-und-Absenk-Hub der zweiten Anhebe-und-Absenk-Einrichtung (55) ein Hub-Ende erreicht hat, bevor die von dem Lastmessungs-Teilabschnitt (59) gemessene Last die Ziel-Last erreicht hat, nachdem das von dem Halteelement (60) gehaltene Bauteil (P) mit dem Zielobjekt (S) in Kontakt gekommen ist, nach Lösen des Haltens des Bauteils (P) durch das Halteelement (60) die Zielposition ändert und erneut Steuerung zum Anheben und Absenken durchführt, um erneut Druck auf das Bauteil unter Verwendung des Halteelementes (60) auszuüben.

3. Vorrichtung zum Montieren von Bauteilen nach Anspruch 1 oder 2, wobei
die Steuerungseinrichtung (70) so ausgeführt ist, dass sie als die Steuerung zum Anheben und Absenken, nachdem sie Antriebssteuerung der ersten Anhebe-und-Absenk-Einrichtung (50) so durchgeführt hat, dass das Halteelement (60) an die Zielposition abgesenkt worden ist, das Antreiben der ersten Anhebe-und-Absenk-Einrichtung (50) stoppt, dann Antriebssteuerung des zweiten Anhebe-und-Absenk-Elementes (55) durchführt, um das Halteelement (60) weiter abzusenken, so dass die von dem Lastmessungs-Teilabschnitt (59) gemessene Last die Ziel last ist.

4. Vorrichtung zum Montieren von Bauteilen nach einem der Ansprüche 1 bis 3, wobei
die Steuerungseinrichtung (70) so ausgeführt ist, dass sie auf Basis der von dem Lastmessungs-Teilabschnitt (59) gemessenen Last feststellt, ob das von dem Halteelement (60) gehaltene Bauteil (P) mit dem Zielobjekt (S) in Kontakt gekommen ist.

## Revendications

1. Appareil de montage de composant (10) pour maintenir un composant (P) et monter le composant (P) sur un objet cible (S), l'appareil de montage de composant (10) comprenant :
un élément de maintien (60) configuré pour maintenir un composant (P) ;
une tête (40) ;
un premier dispositif de levage et de descente (50) configuré pour lever et abaisser un élément de levage et de descente (52) par rapport à la tête (40) ;
un second dispositif de levage et de descente (55), avec une course de levage et de descente plus courte que la course de levage et de descente du premier dispositif de levage et de descente (50), configuré pour lever et abaisser relativement l'élément de maintien (60) par rapport à l'élément de levage et de descente (52) ;
une section de mesure de la charge (59) configurée pour mesurer une charge appliquée à l'élément de maintien (60) ; et
un dispositif de commande (70) configuré pour, lors du montage du composant (P) maintenu par l'élément de maintien (60) sur l'objet cible (S), effectuer une commande de levage et de descente du premier dispositif de levage et de descente (50) pour abaisser l'élément de maintien (60) jusqu'à une position cible, et effectuer une commande d'entraînement du second dispositif de levage et de descente (55) pour abaisser davantage l'élément de maintien (60) de sorte qu'une charge mesurée par la section de mesure de charge (59) soit une charge cible, et ensuite effectuer le relâchement du maintien du composant (P) par l'élément de maintien (60), dans lequel
le dispositif de commande (70) est configuré pour, lorsque la course de levage et de descente du second dispositif de levage et de descente (55) a atteint une fin de course avant que le composant (P) maintenu par l'élément de maintien (60) n'entre en contact avec l'objet cible (S), modifier la position cible, effectuer à nouveau la commande de levage et de descente, et relâcher le maintien du composant (P) par l'élément de maintien (60).

2. Appareil de montage de composant (10) pour maintenir un composant (P) et lever le composant (P) sur un objet cible (S), l'appareil de montage de composants (10) comprenant :
un élément de maintien (60) configuré pour maintenir un composant (P) ;
une tête (40) ;
un premier dispositif de levage et de descente (50) configuré pour lever et abaisser un élément de levage et de descente (52) par rapport à la tête (40) ;
un second dispositif de levage et de descente (55), avec une course de levage et de descente plus courte que la course de levage et de descente du premier dispositif de levage et de descente (50), configuré pour lever et abaisser relativement l'élément de maintien (60) par rapport à l'élément de levage et de descente (52) ;
une section de mesure de la charge (59) configurée pour mesurer une charge appliquée à l'élément de maintien (60) ; et
un dispositif de commande (70) configuré pour, lors du montage du composant (P) maintenu par l'élément de maintien (60) sur l'objet cible (S), effectuer une commande de levage et de descente du premier dispositif de levage et de descente (50) pour abaisser l'élément de maintien (60) jusqu'à une position cible, et effectuer une commande d'entraînement du second dispositif de levage et de descente (55) pour abaisser davantage l'élément de maintien (60) de sorte qu'une charge mesurée par la section de mesure de charge (70) soit une charge cible, et ensuite effectuer le relâchement du maintien du composant (P) par l'élément de maintien (60), dans lequel
le dispositif de commande (70) est configuré pour, lorsque la course de levage et de descente du second dispositif de levage et de descente (55) a atteint une fin de course avant que la charge mesurée par la section de mesure de la charge (59) ait atteint la charge cible après que le composant (P) maintenu par l'élément de maintien (60) a touché l'objet cible (S), après avoir relâché le maintien du composant (P) par l'élément de maintien (60), modifier la position cible et effectuer à nouveau la commande de levage et de descente pour appliquer à nouveau une pression sur le composant à l'aide de l'élément de maintien (60).

3. Appareil de montage de composants selon les revendications 1 ou 2, dans lequel le dispositif de commande (70) est configuré pour, en tant que commande de levage et de descente, après avoir effectué la commande d'entraînement du premier dispositif de levage et de descente (50) de sorte que l'élément de maintien (60) ait été abaissé jusqu'à la position cible, arrêter l'entraînement du premier dispositif de levage et de descente (50), puis effectuer la commande d'entraînement du second élément de levage et de descente (55) pour abaisser davantage l'élément de maintien (60) de sorte que la charge mesurée par la section de mesure de la charge (59) soit la charge cible.

4. Appareil de montage de composant selon l'une des revendications 1 à 3, dans lequel le dispositif de commande (70) est configuré pour déterminer si le composant (P) tenu par l'élément de maintien (60) est entré en contact avec l'objet cible (S) en fonction de la charge mesurée par la section de mesure de la charge (59).
